# EUROPEAN PATENT APPLICATION

(11) **EP 2 192 826 A1**
(43) Date of publication of application: **02.06.2010**
(21) Application number: 09174328.6
(22) Date of filing: 28.10.2009
(51) Int. Cl.: H05K 5/00, H05K 5/02, G02B 6/44

(54) **Rotary telecom casing**

(30) Priority: 27.11.2008 PL 11786008 U
(71) Applicant: INTEGRA Pawel Mróz, 33-100 Tarnów (PL)
(72) Inventor: Mróz, Pawel, 33-100 Tarnów (PL)
(74) Representative: Grzaka, Andrzej

(57) **Abstract**

The present Utility Model relates to a rotary telecom casing (i.e. a rotary casing for use in telecommunication equipments) applied in ICT, as well as in electronic & electrical engineering, consisting of a rack and one, at least, cassette, which has rotary joint (9) allowing for changing the position of the cassette (1) and the rack (11) in a rotating motion around the axis (8), by 90°.

## Description

The present Utility Model relates to a rotary telecom casing (i.e. a rotary casing for use in telecommunication equipments) applied in ICT¹⁾, as well as in electronic & electrical engineering.

A variety of casings of different forms are known and used in the high- and low-voltage engineering fields, such as: electrical engineering, electronic engineering, automatic control engineering, or ICT. There are free standing casings, desk-type casing, 'soho'-type casings, casings with no assembly jigs, casings to be built-in, and RACK-type casings. Usually, those casings are rigidly mounted so that it is impossible to move them.

Moreover, it is known that some casings can be built-in; they can be moved from a row of other casings in order to get into their interiors. As for RACK-type casing mounted in a non-rigid (movable) manner, special tracks are used. In this case, as soon as the bolts sitting in metal fixtures are unscrewed, the whole casing, or part thereof, can be moved forward (following the straight-line motion) from the box where it is installed. To move the casing in this way, the cables passing through the casing must be long enough to avoid their disconnection or damage when the casing is moved. Additionally, the flexibility of those connecting cables must be fitting.

The present Utility Model is directed to facilitate the access to electric and electronic devices, among other things, to wiring in computer networks mounted in inaccessible places. The device according to the Utility Model solves the problem of accessibility to sub-assemblies placed inside the casing and eliminates the necessity of disassembling the entire casing or some components thereof.
1) ICT = **I**nformation and **C**ommunication **T**echnology

The essence of the solution according to the Utility Model is a rotary telecom casing consisting of a rack and of, at least, one cassette; the feature characterizing the casing is its rotary joint connection that makes it possible to change the location of the cassette, and the rack by a 90° angle in the rotary motion around the axis. Preferably, the cassette has one panel with a fixture connecting the panel with the joint rotating around the axis; the joint is fastened to the rack. Preferably, this rack has two parallel placed through holes, designed for two connecting cables to pass through. Preferably, the cassette has a pivoting lid that slightly opens upwards.

The rotary telecom casing, of the Utility Model, makes it possible to conveniently access the inside of the casing even when there are several casings mounted in a row.

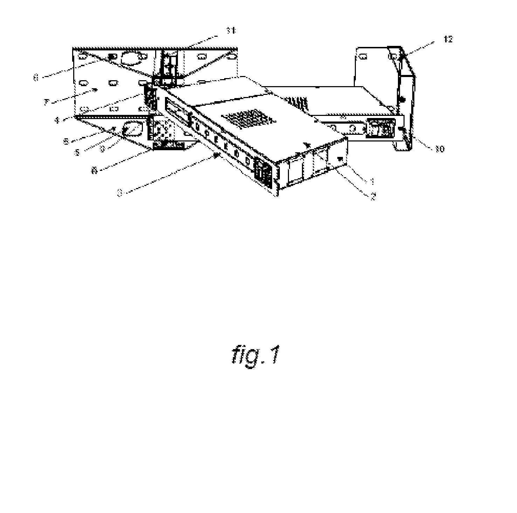

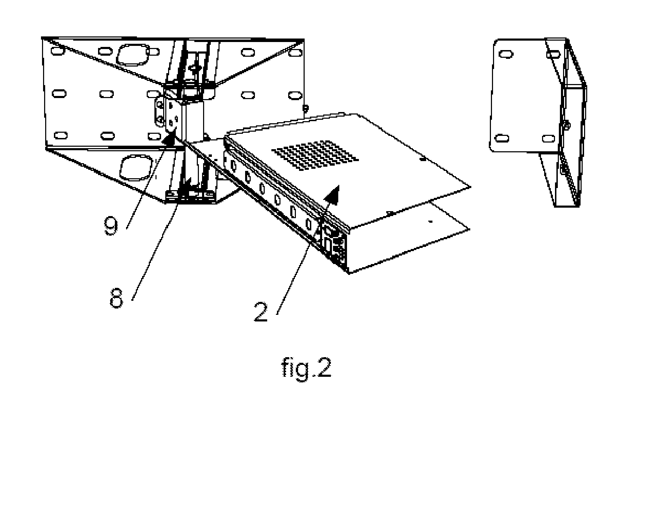

The object under this Utility Model is represented in Fig. 1 and Fig. 2. Fig. 1 shows a vista of the rotary telecom casing, and Fig. 2 shows a detail of the joint and rotation axis.

The rotary telecom casing of the Utility Model consists of a cassette 1 with a pivoting lid 2 allowing free and easy access to the inside of the cassette 1 equipped with a panel 3 with a fixture 4 for fastening this cassette 1 to the rotary joint 9 in the rack 11. The rack 11 consists of two trapeziums 6 and the base 7 that inseparably inter-connects those two trapeziums 6. The base 7 has installation holes. The two trapeziums 6 are, on their other side, connected by a tube constituting a rotation axis 8 of the joint 9 applied to fix the cassette 1. The rack 11 has two parallel placed through holes 5 provided for connecting cables to pass through. The other, right-hand side of the rack 11 is a channel section 12 with installation holes and with a fixture 10 to stabilize the position of the cassette 1.

The rotary telecom casing of to the Utility Model makes it possible to swing out the cassette 1 in such a way that the access to the inside of the cassette 1 is easier. This cassette 1 rotates by 90° around the axis 8 and then the lid 2 of the cassette 1 can be easily opened. To open the lid 2 and to get into the inside of the cassette 1, the clamping screw in the channel section 12 is to be unscrewed to release the fixture 10. Next, the panel 3 has to be held and swung out. The cassette 1 starts to rotate, changing its position towards the rack 11; it rotates through 90° compared to its initial position. Now, the cassette 1 is in such a position that its lid 2 can be opened and its inside is accessible. Owing to the fact that the fixture 4 is fixed to the rotary joint 9 in the rack 11 fastened to the base, no additional supporting elements are required for the cassette 1. This fact gives freedom when servicing such casings.

## Claims

1. A rotary telecom casing consisting of a rack and one, at least, cassette, **wherein** the cassette 1 has a rotary joint 9 allowing for changing the position of the cassette 1 and the rack 11 in a rotating motion around the axis 8, by 90°.

2. The rotary telecom casing according to Claim 1, **wherein** the cassette 1 has a panel 3 connected by way of a fixture 4 with the rotary joint 9 that rotates around the axis 8 fixed to the rack 11.

3. The rotary telecom casing according to Claim 1 or 2, **wherein** the rack 11 has two parallel placed through holes 5 designed for connecting cables to pass through.

4. The rotary telecom casing according to Claim 1, 2 or 3, **wherein** the cassette 1 has a pivoting lid 2.
